# EUROPEAN PATENT SPECIFICATION

(11) **EP 3 021 559 B1**
(45) Date of publication and mention of the grant of the patent: **05.08.2020**
(21) Application number: 15170918.5
(22) Date of filing: 05.06.2015
(51) Int. Cl.: H04M 1/02

(54) **HOUSING, ELECTRONIC DEVICE USING SAME, AND METHOD FOR MAKING SAME**
GEHÄUSE, ELEKTRONISCHE VORRICHTUNG DAMIT UND HERSTELLUNGSVERFAHREN DAFÜR
BOITIER, DISPOSITIF ELECTRONIQUE UTILISANT CELUI-CI ET SON PROCEDE DE FABRICATION

(30) Priority: 23.10.2014 CN 201410569879
(43) Date of publication of application: 18.05.2016
(73) Proprietor: Shenzhen Futaihong Precision Industry Co., Ltd., Shenzhen City, Guangdong Province 518109 (CN); FIH (Hong Kong) Limited, Hong Kong (HK)
(72) Inventor: GU, Chang-Hai, 518109 ShenZhen City (CN); LIU, Xiao-Kai, 518109 ShenZhen City (CN)
(74) Representative: CMS Cameron McKenna Nabarro Olswang LLP

(56) References cited:
- EP-A2- 2 498 336
- WO-A1-2011/076582
- CN-A- 103 929 910
- DE-U1-202011 103 932
- US-A1- 2014 126 172

## Description

### FIELD

The subject matter herein generally relates to a housing, an electronic device using the housing, and a method for making the housing.

### BACKGROUND

Metal housings are widely used for electronic devices.

WO 2011/076582A1 discloses an antenna arrangement for a mobile device. The mobile device comprises radio frequency circuits and a ground plane (317). The antenna arrangement comprises a conductive element (300) and at least one feeding element (306). The feeding element comprising a conductive pattern is arranged to be connected to the radio frequency circuits wherein the conductive element is a sheet having an outer first surface (315) and an inner second surface (316). The conductive element comprises at least two radiating elements (301, 302). The radiating elements are arranged to be fed through said feeding element. The radiating elements are physically separated from each other by isolation means (303) and said feeding element has an extension plane with one side of the feeding element facing the inner second surface of the conductive element with a gap between the conductive element and the conductive pattern of said feeding element.

CN 103929910 A1 provided is a shell. The shell is used for an electronic device. The electronic device comprises a body and the shell, wherein the shell can be buckled to the body, and an antenna capable of receiving and/or transmitting wireless signals is arranged on the body or the shell. The shell is made of a first material, and the wireless signals cannot penetrate through the first material. A hollow-out pattern is arranged on the shell, the position, on the shell, of the hollow-out pattern corresponds to the antenna so that the wireless signals can penetrate through the shell through the hollow-out pattern. The invention further discloses the electronic device. By the adoption of the technical scheme, the hollow-out pattern can be utilized for covering an antenna area, and the electronic device can be more beautiful.

### SUMMARY

According to a first aspect of the disclosure, a housing according to claim 1 is provided.

According to a second aspect of the disclosure, a method of making a housing according to claim 10 is provided.

According to a third aspect of the disclosure, an electronic device according to claim 14 is provided.

### BRIEF DESCRIPTION OF THE FIGURES

Implementations of the present technology will now be described, by way of example only, with reference to the attached figures.
FIG. 1 is an isometric view of an electronic device, according to an exemplary embodiment.
FIG. 2 is a partial, isometric view of a housing of the electronic device shown in FIG. 1.
FIG. 3 is similar to FIG. 2, but shown from another angle.
FIG. 4 is an exploded, isometric view of the housing shown in FIG. 1.
FIG. 5 is a cross-sectional view of the housing along line V-V of FIG. 2.
FIG. 6 is an enlarged view of the housing of circled portion VI in FIG. 5.
FIG. 7 is an isometric view of metal strips during the process of making the housing of FIG. 2.
FIG. 8 is an isometric view of a metal strip assembly during the process of making the housing of FIG. 2.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, methods, procedures and components have not been described in detail so as not to obscure the related relevant feature being described. Also, the description is not to be considered as limiting the scope of the embodiments described herein. The drawings are not necessarily to scale and the proportions of certain parts may be exaggerated to better illustrate details and features of the present disclosure.

The term "comprising" when utilized, means "including, but not necessarily limited to"; it specifically indicates open-ended inclusion or membership in the so-described combination, group, series and the like. The term "coupled" when utilized, means "either a direct electrical connection between the things that are connected, or an indirect connection through one or more passive or active intermediary devices, but not necessarily limited to".

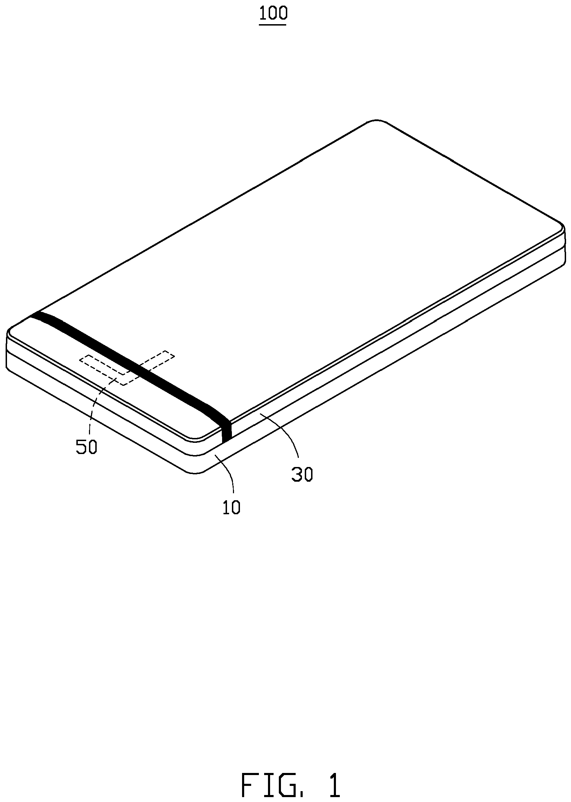

FIG. 1 illustrates an electronic device 100 according to an exemplary embodiment. The electronic device 100 can be, but not limited to, a mobile phone, a personal digital assistant or a panel computer. The electronic device 100 includes a main body 10, a housing 30 assembled to the main body 10, and an antenna 50 located inside the housing 30.

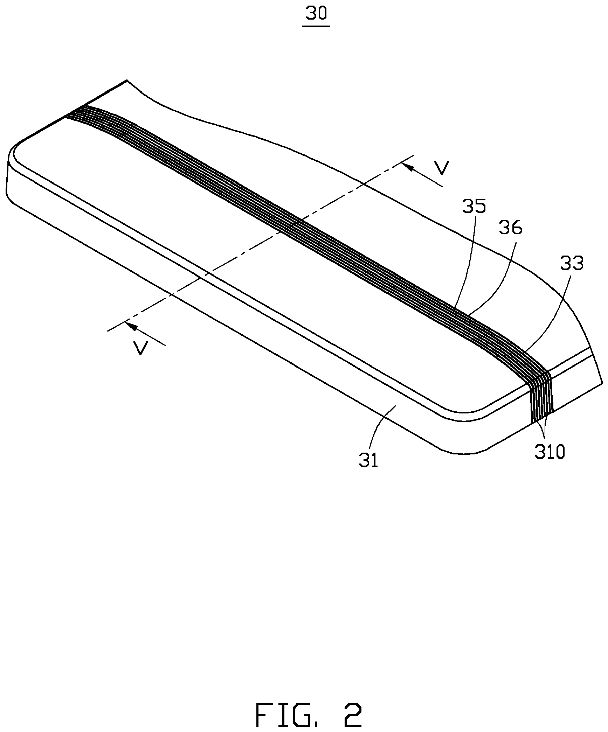

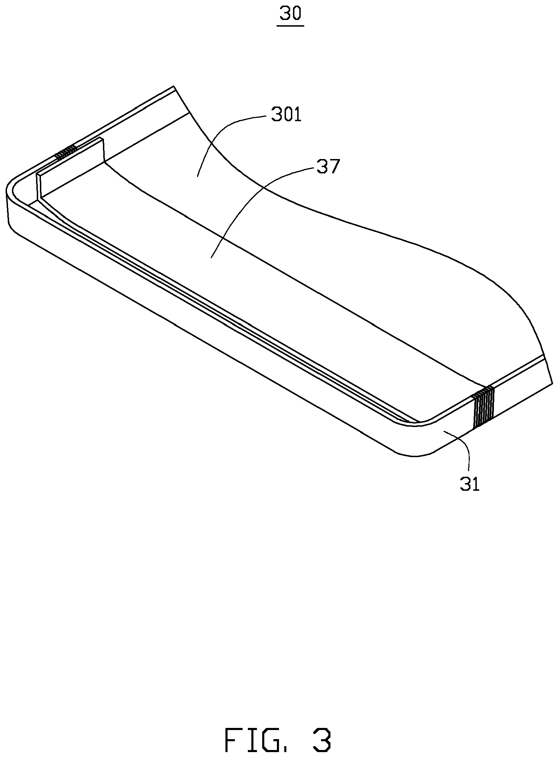

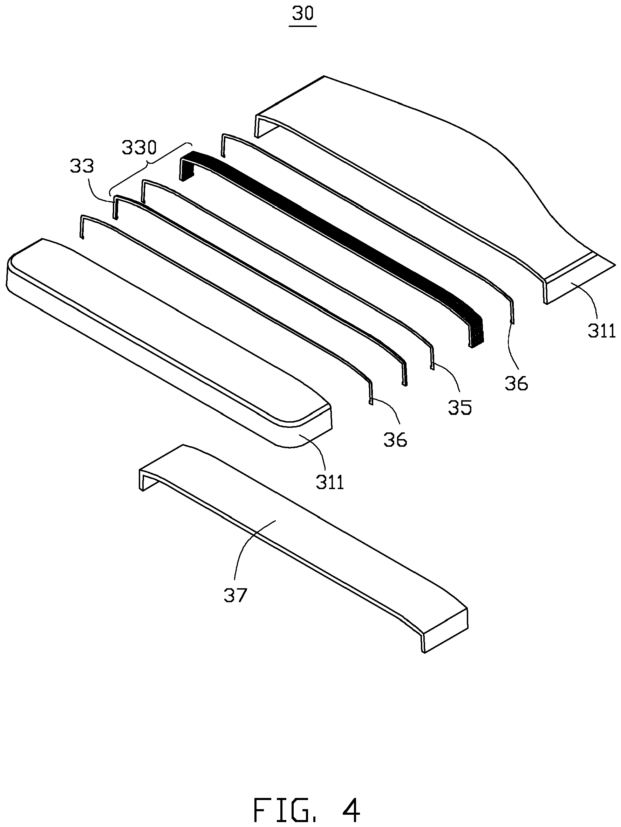

FIGS. 2-4 illustrate in one exemplary embodiment, the housing 30 can be a back cover of the electronic device 100. The housing 30 includes a base 31, a plurality of metal strips 33, a plurality of adhering layers 35, a plurality of insulating layers 36, and a combining layer 37 formed on the base 31. The base 31 further defines a receiving space 301 cooperating with main body 10 to receive internal elements of the electronic device 100, such as the antenna 50, battery (not shown) and so on.

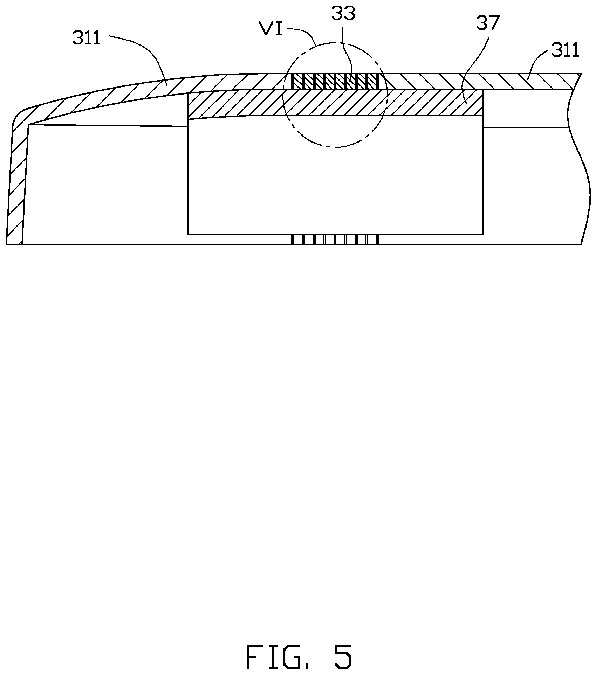

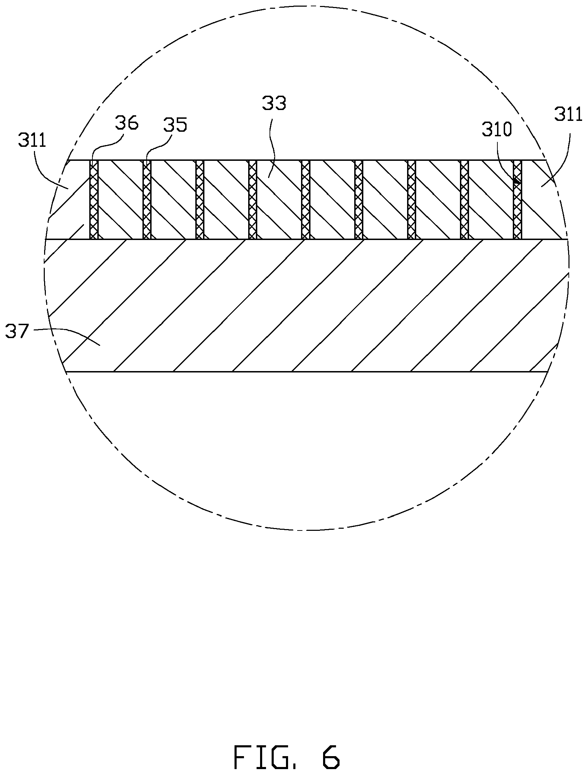

FIGS. 5-6 illustrate the base 31 is three-dimensional. In one exemplary embodiment, the base 31 has a substantially U-shaped cross-section. A plurality of openings 310 is defined in the base 31 corresponding with the antenna 50 received in the receiving space 301 and running through an outer surface and an inner surface of the base 31. The plurality of openings 310 divides the base 31 into at least two main portions 311. The at least two main portions 311 can be separated from each other or connected to each other through at least one portion of the base 31 adjacent to the openings 30. In one exemplary embodiment, the base 31 includes one opening 310 (shown in FIG. 6) dividing the base 31 into two separated main portions 311. The base 31 is made of metal. The metal can be selected from a group consisting of aluminum alloy, titanium alloy, magnesium alloy, and stainless steel.

Each metal strip 33 is also made of metal selected from a group consisting of aluminum alloy, titanium alloy, magnesium alloy, and stainless steel.

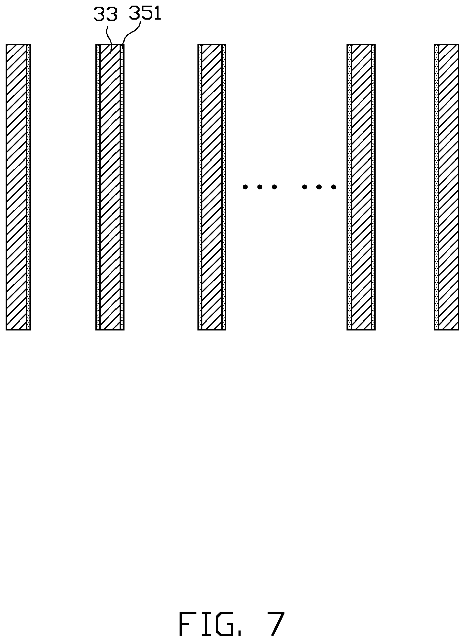

The metal strips 33, adhering layers 35, and the insulating layers 36 are received in the opening 310 and sandwiched between the two main portions 310. Each metal strip 33 alternates with one adhering layer 35. Each adhering layer 35 is positioned between each two adjacent metal strips 33, thereby adhering all the metal strips 33 together to form a metal strip assembly 330. The adhering layers 36 can be formed from plastic films 351 (shown FIG. 7) made of polycarbonate (PC), polyamide (PA), or polyethylene terephthalate (PET) through hot pressing. The insulating layers 36 are positioned between each main portion 311 and the metal strip 33 adjacent to the main portion 311, thereby physically but not electrically connecting the main portions 311 to the corresponding adjacent metal strips 33. The insulating layer 36 can be made of one or more resins selected from a group consisting of polyphenylene sulfide (PPS), polybutylene terephthalate (PBT), polyamide (PA), polyethylene terephthalate (PET), polytrimethylene terephthalate (PTT), polyetherimide (PEI), polyether ether ketone (PEEK), poly(ethylene-co-1,4-cyclohexylenedimethylene terephthalate) (PCT), and their modified materials, through injection molding.

In other embodiments, the insulating layers 36 also can be formed by the plastic films 351 made of polycarbonate (PC), polyamide (PA), or polyethylene terephthalate (PET), through hot pressing.

Each metal strip 33 has a thickness of about 0.1 mm to about 1.0 mm along a direction from an adjacent adhering layer 35 located at one side of the metal strip 33 to another adjacent adhering layer 35 located at an opposite side of the metal strip 33. Each adhering layer 35 has a thickness of about 20 µm to about 0.8 mm along a direction from a metal strip 33 located at one side of adhering layer 35 to another adjacent metal strip 33 located at an opposite side of the adhering layer 35, thereby creating a distance between each two adjacent metal strips 33 of about 20 µm to about 0.8 mm. In other embodiments, the thickness of each adhering layer 35 is about 0.15 mm. Each insulating layer 36 has a thickness of about 20 µm to about 0.8 mm along a direction from each main portion 311 to an adjacent metal strip 33, thereby creating a distance between each main portion 311 and the adjacent metal strip 33 of about 20 µm to about 0.8 mm. In the embodiment, the thickness of each insulating layer 36 is also about 0.15 mm. Therefore, requirements for reducing interference from the metal housing 30 with the antenna 30 can be satisfied.

The metal strips 33 are substantially U-shaped corresponding to the main portions 311. Each adhering layer 35 is adhered to adjacent metal strips 33. Each adhering layer 35 is also substantially U-shaped to engage with the shape of the metal strips 33.

The combining layer 37 is formed on the internal surface of the base 31 (i.e. a surface of the base 31 facing the main body 10). The combining layer 37 covers each metal strip 33, each adhering layer 35, each insulating layer 36, and entirely or partially covers an end portion of the main portion 311 connected to the insulating layers 36. As such, the main portions 311, the metal strips 33, the adhering layers 35, and the insulating layers 36 are bonded together through the combining layer 37. The combining layer 37 can further enhance a bonding strength among the main portions 311, the metal strips 33, the adhering layers 35, and the insulating layers 36, respectively. The combining layer 37 can be made of one or more resins selected from of a group consisting of polyphenylene sulfide (PPS), polybutylene terephthalate (PBT), polyamide (PA), polyethylene terephthalate (PET), polytrimethylene terephthalate (PTT), Polyetherimide (PEI), polyether ether ketone (PEEK), poly(ethylene-co-1,4-cyclohexylenedimethylene terephthalate) (PCT), and their modified materials.

When the housing 30 is assembled to the main body 10, the metal strip assembly 330 formed by the metal strips 33 and the adhering layers 35 aligns with the antenna 40. The base 31 can be coupled with the antenna and serves as an extra antenna of the electronic device 100. In addition, signals of the antenna 50 can pass through the adhering layers 35 and the insulating layers 36. Therefore, radiation efficiency of antenna 50 can be increased.

In another embodiment, the base 31 is not coupled with the antenna and does not serve as the extra antenna. The signals of the antenna 50 can pass through the adhering layers 35 and the insulating layers 36 to increase the radiation efficiency of antenna 50.

An exemplary method for making the housing 30 can include the following steps.

The base 31 having a three-dimensional shape is provided. The base 31 defines the plurality of openings 310 communicating through the base 31 and corresponding to the antenna 50. The openings 310 divide the base 31 into at least two main portions 311. The at least two main portions 311 can be separated from each other or connected to each other through at least one portion of the base 31 adjacent to the openings 30. In one exemplary embodiment, the base 31 includes one opening 310 dividing the base 31 into two separated main portions 310. The base 31 can be made by casting, punching, or computer numerical control machine. The base 31 is made of metal. The metal can be selected from a group consisting of aluminum alloy, titanium alloy, magnesium alloy, and stainless steel.

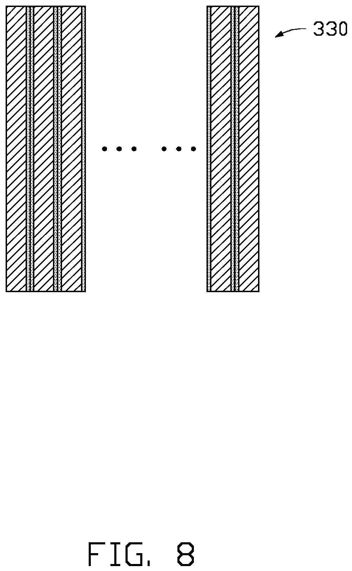

FIGS. 7 and 8 illustrate the plurality of metal strips 33 are provided. The plastic films 351 which can be melted upon heating are formed on each side surface of each metal strip 33 facing the adjacent metal strip 33. Each metal strip 33 is made of metal. The metal can be selected from a group consisting of aluminum alloy, titanium alloy, magnesium alloy, and stainless steel. The plastic film 351 can be made of polyamide (PA), polycarbonate (PC) or polyethylene terephthalate (PET).

The metal strips 33 formed with plastic films 351 are overlapping and connected together. Each two adjacent metal strips 33 are spaced by the plastic films 351. The overlapped metal strips 33 are heated to melt the plastic films 351. The plastic films 351 are then solidified, thereby adhering all the metal strips 33 together to form the metal strip assembly 330. In one exemplary embodiment, the metal strips 33 are placed in a mold (not shown) aligned with each other. The metal strips 33 are heated to melt the plastic films 351 positioned on each side surface of each metal strip 33 facing the adjacent metal strip 33, and then cooled to solidify the melted plastic films 351. Thus, the metal strips 33 are adhered together, and the plastic films 351 positioned between each two adjacent metal strips 33 form the plurality of adhering layers 35 sandwiched between each two adjacent metal strips 33. Each adhering layer 35 has a thickness of about 20 µm to about 0.8 mm along a direction from a metal strip 33 located at one side of adhering layer 35 to another adjacent metal strip 33 located at an opposite side of the adhering layer 35.

The metal strip assembly 330 and the two main portions 311 are placed in a forming mold (not shown). The metal strip assembly 330 is received in the opening 310 and sandwiched between the two main portions 311. A gap (not shown) is defined between each main portion 311 and the metal strip assembly 330. A distance between each main portion 311 and the metal strip assembly 330 is substantially equal to the thickness of each adhering layer 35 along a direction from a metal strip 33 located at one side of adhering layer 35 to another adjacent metal strip 33 located at an opposite side of the adhering layer 35. Liquid molten plastic is injected into the mold filling the remaining gaps between each main portion 311 and the metal strip assembly 330. The plastic is solidified to connect the main portions 311 and the metal strip assembly 330 together and forms the insulating layer 36 in each gap after cooling.

In other embodiments, the plastics can also be formed on the inner surface of the base 31 and cover each metal strip 33, each adhering layer 35, each insulating layer 36, and entirely or partially cover an end portion of each main portion 311 connected to the insulating layer 36, thereby forming the combining layer 37 after cooling. The combining layer 37 can further enhance a bonding strength among the main portions 311, the metal strips 33, the adhering layers 35, and the insulating layers 36, respectively.

In addition, the insulating layers 36 can be also formed by the same means as forming the adhering layers 35. That is, the plastic films 351 are formed on two side surfaces of each metal strip 33 and the metal strips 33 and the main portions 311 are bonded together through hot pressing the plastic films 351.

A redundant portion of each metal strip 33 exposed from the outer surface of the base 31 can be removed by numerical control machines so the metal strips 33 and the base 31 can obtain a smooth appearance. Finally, the housing 30 can be polished or decorated.

The plurality of metal strips 33 and the plurality of adhering layers 35 are formed on the housing 30 corresponding to the antenna 50 to reduce interference from the housing 30 to the antenna 50. In addition, the base 31 can be coupled with the antenna 50 to serve as the extra antenna of the electronic device 100 to increase the radiation efficiency of the antenna 50. The metal strips 33 and the main portions 311 are aligned with each other. Each adhering layer 35 is positioned between two adjacent metal strips 33. Each insulating layer 36 is positioned between each main portion 311 and the adjacent metal strip 33. Thus, the metal strips 33 and the main portions 311 are connected to each other by the adhering layers 35 and the insulating layers 36. The combining layer 37 formed on the inner surface of the base 31 enhances the bonding strength among the main portion 311, the metal strips 33 the adhering layers 35, and the insulating layers 36 respectively.

It is to be understood, however, that even through numerous characteristics and advantages of the present disclosure have been set forth in the foregoing description, together with details of assembly and function, the disclosure is illustrative only, and changes may be made in detail, especially in the matters of shape, size, and arrangement of parts within the principles of the disclosure to the full extent indicated by the broad general meaning of the terms in which the appended claims are expressed.

## Claims

1. A housing (30) comprising a base (31) made of metal material, the base (31) having a plurality of main portions (311) separated by one or more openings (310) formed therein;
wherein the housing (30) further comprising a metal strip assembly (330) and insulating layers (36), the metal strip assembly (330) is positioned within the openings (310) and is not electrically connected to the main portions (311), the metal strip assembly (330) is formed by a series of metal strips (33) and a plurality of adhering layers (35), the series of metal strips (33) and the plurality of adhering layers (35) are alternately placed; and the insulating layers (36) is positioned between the metal strip assembly (330) and the main portions (311).

2. The housing (30) as claimed in claim 1, wherein the plurality of openings (310) divide the base (31) into at least two main portions (311), the at least two main portions (311) are separated from each other or connected to each other through at least one portion of the base (31) adjacent to the openings (310).

3. The housing (30) as claimed in claim 1, wherein the thickness of each metal strip (33) is about 0.1 mm to about 1.0 mm along a direction from an adjacent adhering layer (35) located at one side of the metal strip (33) to another adjacent adhering layer (35) located at an opposite side of the metal strip (33).

4. The housing (30) as claimed in claim 1, wherein each adhering layer (35) has a thickness of about 20 µm to about 0.8 µm along a direction from a metal strip (33) located at one sided of adhering layer (35) to another adjacent metal strip (33) located at an opposite side of the adhering layer (35).

5. The housing (30) as claimed in claim 1, wherein each adhering layer (35) is made of polycarbonate, polyamide, or polyethylene terephthalate.

6. The housing (30) as claimed in claim 1, wherein each insulating layer (36) has a thickness of about 20 µm to about 0.8 µm along a direction from a metal strip (33) located at one sided of adhering layer (35) to another adjacent metal strip (33) located at an opposite side of the adhering layer (35).

7. The housing (30) as claimed in claim 1, wherein each insulating layer (36) is made of one or more resins selected from a group consisting of polyphenylene sulfide, polybutylene terephthalate, polyamide, polyethylene terephthalate, polytrimethylene terephthalate, polyetherimide, poly ether ether ketone, poly(ethylene-co-1,4-cyclohexylenedimethylene terephthalate), and their modified materials.

8. The housing (30) as claimed in claim 1, wherein the base (31) comprises a receiving space (301) and an internal surface facing the receiving space (301); a combining layer (37) is attached to the internal surface, the combining layer (37) covers the metal strips (33), the adhering layers (35), the insulating layers (36), and totally or partly covers an end of the main portion (311) connected with the insulating layers (36).

9. The housing (30) as claimed in claim 8, wherein the combining layer (37) is made of one or more resins selected from a group consisting of polyphenylene sulfide, polybutylene terephthalate, polyamide, polyethylene terephthalate, polytrimethylene terephthalate, polyetherimide, poly ether ether ketone, poly(ethylene-co-1,4-cyclohexylenedimethylene terephthalate), and their modified materials.

10. A method of making a housing (30) comprising providing a base (31) made of metal material and defining a plurality of openings (310);
wherein the method further comprises: providing a plurality of metal strips (33), forming a plastic film (351) at each side surface of each metal strip (33); overlapping the metal strips (33) with the plastic films (351)_and heating the overlapped metal strips (33) so that the plastic films (351) are melted and then solidified to form a plurality of adhering layers (35) adhering the metal strips (33) together as a metal strip assembly (330); placing the metal strip assembly (330) and the base (31) in a forming mold with the metal assembly (330) received in the openings (310), defining a gap between each side of the metal strip assembly (330) and the base (31); and injecting liquid molten plastics into the forming mold so that the plastics is filled into the gaps so as to connect the metal strip assembly (330) and the base (31) together but being electrically isolated to form the housing (30).

11. The method as claimed in claim 10, wherein the plastic films (351) are made of polycarbonate, polyamide, or polyethylene terephthalate.

12. The method as claimed in claim 10, wherein the plastics filled into the gaps form a plurality of insulating layers (36).

13. The method as claimed in claim 10, wherein in the step of injecting liquid molten plastics into the forming mold, a combining layer (37) is formed on an inner surface of the base (31) covering the adhering layers (35) and the metal strip assembly (330), thereby connecting the base (31), the metal strip assembly (330), and the adhering layers (35) together.

14. An electronic device (100), comprising a main body (10), a housing (30) mounted on the main body (10), and an antenna (50) assembled in the housing (30);
wherein the housing (30) is as claimed in claim 1; and the metal strip assembly (330) is positioned corresponding to the antenna (50) so as to allow signals of the antenna (50) passing through the metal strip assembly (330).

15. The electronic device (100) as claimed in claim 14, wherein the base (31) comprises a receiving space (301) and an internal surface facing the receiving space (301); a combining layer is attached to the internal surface, the combining layer (37) covers the metal strips (33), the adhering layers (35), the insulating layers (36), and totally or partly covers an end of the main portion (311) connected with the insulating layers (36).

## Patentansprüche

1. Gehäuse (30), umfassend eine Basis (31) aus Metallmaterial, wobei die Basis (31) eine Vielzahl von Hauptabschnitten (311) aufweist, die durch eine oder mehrere darin ausgebildete Öffnungen (310) getrennt sind;
wobei das Gehäuse (30) ferner eine Metallstreifenanordnung (330) und Isolierschichten (36) umfasst, wobei die Metallstreifenanordnung (330) innerhalb der Öffnungen (310) positioniert ist und nicht elektrisch mit den Hauptabschnitten (311) verbunden ist, die Metallstreifenanordnung (330) aus einer Reihe von Metallstreifen (33) und einer Vielzahl von Haftschichten (35) ausgebildet ist, die Reihe von Metallstreifen (33) und die Vielzahl von Haftschichten (35) abwechselnd angeordnet sind; und
die Isolierschichten (36) zwischen der Metallstreifenanordnung (330) und den Hauptabschnitten (311) angeordnet sind.

2. Gehäuse (30) nach Anspruch 1, wobei die Vielzahl von Öffnungen (310) die Basis (31) in mindestens zwei Hauptabschnitte (311) teilt, und die mindestens zwei Hauptabschnitte (311) voneinander getrennt oder durch mindestens einen Teil der Basis (31) neben den Öffnungen (310) miteinander verbunden sind.

3. Gehäuse (30) nach Anspruch 1, wobei die Dicke jedes Metallstreifens (33) entlang einer Richtung von einer benachbarten Haftschicht (35), die sich auf einer Seite des Metallstreifens (33) befindet, zu einer anderen benachbarten Haftschicht (35), die sich auf einer gegenüberliegenden Seite des Metallstreifens (33) befindet, etwa 0,1 mm bis etwa 1,0 mm beträgt.

4. Gehäuse (30) nach Anspruch 1, wobei jede Haftschicht (35) entlang einer Richtung von einem Metallstreifen (33), der an einer Seite der Haftschicht (35) angeordnet ist, zu einem weiteren benachbarten Metallstreifen (33), der auf einer gegenüberliegenden Seite der Haftschicht (35) angeordnet ist, eine Dicke von etwa 20 µm bis etwa 0,8 µm aufweist.

5. Gehäuse (30) nach Anspruch 1, wobei jede Haftschicht (35) aus Polycarbonat, Polyamid oder Polyethylenterephthalat besteht.

6. Gehäuse (30) nach Anspruch 1, wobei jede Isolierschicht (36) entlang einer Richtung von einem Metallstreifen (33), der an einer Seite der Haftschicht (35) angeordnet ist, zu einem weiteren benachbarten Metallstreifen (33), der auf einer gegenüberliegenden Seite der Haftschicht (35) angeordnet ist, eine Dicke von etwa 20 µm bis etwa 0,8 µm aufweist.

7. Gehäuse (30) nach Anspruch 1, wobei jede Isolierschicht (36) aus einem oder mehreren Harzen besteht, ausgewählt aus einer Gruppe bestehend aus Polyphenylensulfid, Polybutylenterephthalat, Polyamid, Polyethylenterephthalat, Polytrimethylenterephthalat, Polyetherimid, Polyether Etherketon, Poly(ethylen-co-1,4-cyclohexylendimethylenterephthalat) und deren modifizierten Materialien.

8. Gehäuse (30) nach Anspruch 1, wobei die Basis (31) einen Aufnahmeraum (301) und eine dem Aufnahmeraum (301) zugewandte Innenfläche umfasst;
eine Kombinationsschicht (37) an der Innenfläche angebracht ist, wobei die Kombinationsschicht (37), die Metallstreifen (33), die Haftschichten (35), die Isolierschichten (36) bedeckt und ganz oder teilweise ein mit den Isolierschichten (36) verbundenes Ende des Hauptabschnitts (311) bedeckt.

9. Gehäuse (30) nach Anspruch 8, wobei die Kombinationsschicht (37) aus einem oder mehreren Harzen besteht, ausgewählt aus einer Gruppe bestehend aus Polyphenylensulfid, Polybutylenterephthalat, Polyamid, Polyethylenterephthalat, Polytrimethylenterephthalat, Polyetherimid, Polyether Etherketon, Poly(ethylen-co-1,4-cyclohexylendimethylenterephthalat) und deren modifizierten Materialien.

10. Verfahren zum Erzeugen eines Gehäuses (30), umfassend das Bereitstellen einer Basis (31) aus Metallmaterial und das Definieren einer Vielzahl von Öffnungen (310);
wobei das Verfahren ferner umfasst:
Bereitstellen einer Vielzahl von Metallstreifen (33), wobei an jeder Seitenfläche jedes Metallstreifens (33) eine Kunststofffolie (351) ausgebildet ist;
Überlappen der Metallstreifen (33) mit den Kunststofffolien (351) und Erhitzen der überlappenden Metallstreifen (33), sodass die Kunststofffolien (351) geschmolzen und dann verfestigt werden, um eine Vielzahl von Haftschichten (35), die an den Metallstreifen anhaften (33), zusammen als eine Metallstreifenanordnung (330) auszubilden;
Platzieren der Metallstreifenanordnung (330) und der Basis (31) in einem Formwerkzeug, wobei die Metallanordnung (330) in den Öffnungen (310) aufgenommen wird, wodurch ein Spalt zwischen jeder Seite der Metallstreifenanordnung (330) und der Basis definiert wird (31); und
Einspritzen von flüssigem geschmolzenem Kunststoff in das Formwerkzeug, so dass der Kunststoff in die Spalte gefüllt wird, damit die Metallstreifenanordnung (330) und die Basis (31) miteinander verbunden, aber elektrisch isoliert sind, um das Gehäuse (30) auszubilden.

11. Verfahren nach Anspruch 10, wobei die Kunststofffolien (351) aus Polycarbonat, Polyamid oder Polyethylenterephthalat bestehen.

12. Verfahren nach Anspruch 10, wobei die in die Spalte gefüllten Kunststoffe eine Vielzahl von Isolierschichten (36) ausbilden.

13. Verfahren nach Anspruch 10, wobei bei dem Schritt des Einspritzens von flüssigem geschmolzenem Kunststoff in das Formwerkzeug eine Kombinationsschicht (37) auf einer Innenfläche der Basis (31) ausgebildet wird, die die Haftschichten (35) und die Metallstreifenanordnung (330) bedeckt, wodurch die Basis (31), die Metallstreifenanordnung (330) und die Haftschichten (35) miteinander verbunden werden.

14. Elektronische Vorrichtung (100), umfassend einen Hauptkörper (10), ein an dem Hauptkörper (10) angebrachtes Gehäuse (30) und eine in dem Gehäuse (30) eingebaute Antenne (50);
wobei das Gehäuse (30) wie in Anspruch 1 beansprucht ist; und
die Metallstreifenanordnung (330) entsprechend der Antenne (50) positioniert ist, um Signale der Antenne (50) durch die Metallstreifenanordnung (330) laufen zu lassen.

15. Elektronische Vorrichtung (100) nach Anspruch 14, wobei die Basis (31) einen Aufnahmeraum (301) und eine dem Aufnahmeraum (301) zugewandte Innenfläche umfasst;
eine Kombinationsschicht an der Innenfläche angebracht ist, wobei die Kombinationsschicht (37), die Metallstreifen (33), die Haftschichten (35), die Isolierschichten (36) bedeckt, und ganz oder teilweise ein mit den Isolierschichten (36) verbundenes Ende des Hauptabschnitts (311) bedeckt.

## Revendications

1. Boîtier (30) comprenant une base (31) en matériau métallique, la base (31) ayant une pluralité de parties principales (311) séparées par une ou plusieurs ouvertures (310) formées à l'intérieur de celle-ci ;
dans lequel le boîtier (30) comprenant en outre un ensemble de bandes métalliques (330) et des couches isolantes (36), l'ensemble de bandes métalliques (330) est positionné à l'intérieur des ouvertures (310) et n'est pas relié électriquement aux parties principales (311), l'ensemble de bandes métalliques (330) est formé par une série de bandes métalliques (33) et une pluralité de couches adhérentes (35), la série de bandes métalliques (33) et la pluralité de couches adhérentes (35) sont placées alternativement ; et les couches isolantes (36) sont positionnées entre l'ensemble de bandes métalliques (330) et les parties principales (311).

2. Boîtier (30) selon la revendication 1, dans lequel la pluralité d'ouvertures (310) divisent la base (31) en au moins deux parties principales (311), les au moins deux parties principales (311) sont séparées l'une de l'autre ou reliées entre elles par au moins une partie de la base (31) adjacente aux ouvertures (310).

3. Boîtier (30) selon la revendication 1, dans lequel l'épaisseur de chaque bande métallique (33) est d'environ 0,1 mm à environ 1,0 mm le long d'une direction à partir d'une couche adhérente adjacente (35) située sur un côté de la bande métallique (33) à une autre couche adhérente adjacente (35) située sur un côté opposé de la bande métallique (33).

4. Boîtier (30) selon la revendication 1, dans lequel chaque couche adhérente (35) présente une épaisseur d'environ 20 µm à environ 0,8 µm le long d'une direction à partir d'une bande métallique (33) située sur un côté de la couche adhérente (35) à une autre bande métallique adjacente (33) située sur un côté opposé de la couche adhérente (35).

5. Boîtier (30) selon la revendication 1, dans lequel chaque couche adhérente (35) est en polycarbonate, polyamide ou polyéthylène téréphtalate.

6. Boîtier (30) selon la revendication 1, dans lequel chaque couche isolante (36) présente une épaisseur d'environ 20 µm à environ 0,8 µm le long d'une direction à partir d'une bande métallique (33) située sur un côté de la couche adhérente (35) à une autre bande métallique adjacente (33) située sur un côté opposé de la couche adhérente (35).

7. Boîtier (30) selon la revendication 1, dans lequel chaque couche isolante (36) est constituée d'une ou plusieurs résines choisies dans un groupe constitué de sulfure de polyphénylène, de téréphtalate de polybutylène, de polyamide, de téréphtalate de polyéthylène, de téréphtalate de polytriméthylène, de polyétherimide, de polyéther éther cétone, de poly(éthylène-co-1,4-cyclohexylènediméthylène téréphtalate) et de leurs matériaux modifiés.

8. Boîtier (30) selon la revendication 1, dans lequel la base (31) comprend un espace de réception (301) et une surface interne faisant face à l'espace de réception (301) ;
une couche de combinaison (37) est fixée à la surface interne, la couche de combinaison (37) recouvre les bandes métalliques (33), les couches adhérentes (35), les couches isolantes (36) et recouvre totalement ou partiellement une extrémité de la partie principale (311) reliée aux couches isolantes (36).

9. Boîtier (30) selon la revendication 8, dans lequel la couche de combinaison (37) est constituée d'une ou plusieurs résines choisies dans un groupe constitué de sulfure de polyphénylène, de téréphtalate de polybutylène, de polyamide, de téréphtalate de polyéthylène, de téréphtalate de polytriméthylène, de polyétherimide, de polyéther éther cétone, de poly(éthylène-co-1,4-cyclohexylènediméthylène téréphtalate) et de leurs matériaux modifiés.

10. Procédé de fabrication d'un boîtier (30) comprenant la fourniture d'une base (31) en matériau métallique et la définition d'une pluralité d'ouvertures (310) ;
dans lequel le procédé comprend en outre : la fourniture d'une pluralité de bandes métalliques (33), formant un film plastique (351) sur chaque surface latérale de chaque bande métallique (33) ; le chevauchement des bandes métalliques (33) avec les films plastiques (351) et le chauffage des bandes métalliques superposées (33) de sorte que les films plastiques (351) sont fondus puis solidifiés pour former une pluralité de couches adhérentes (35) adhérant aux bandes métalliques (33) ensemble sous forme d'un ensemble de bandes métalliques (330) ; le placement de l'ensemble de bandes métalliques (330) et de la base (31) dans un moule de formage avec l'ensemble métallique (330) reçu dans les ouvertures (310), la définition d'un interstice entre chaque côté de l'ensemble de bandes métalliques (330) et de la base (31) ; et l'injection des plastiques liquides fondus dans le moule de formage de sorte que les plastiques remplissent les interstices de manière à relier l'ensemble de bandes métalliques (330) et la base (31) ensemble tout en étant isolés électriquement pour former le boîtier (30).

11. Procédé selon la revendication 10, dans lequel les films plastiques (351) sont en polycarbonate, polyamide ou téréphtalate de polyéthylène.

12. Procédé selon la revendication 10, dans lequel les plastiques qui remplissent les interstices forment une pluralité de couches isolantes (36).

13. Procédé selon la revendication 10, dans lequel à l'étape d'injection de plastiques liquides fondus dans le moule de formage, une couche de combinaison (37) est formée sur une surface interne de la base (31) recouvrant les couches adhérentes (35) et l'ensemble de bandes métalliques (330), reliant ainsi la base (31), l'ensemble de bandes métalliques (330) et les couches adhérentes (35) ensemble.

14. Dispositif électronique (100), comprenant un corps principal (10), un boîtier (30) monté sur le corps principal (10) et une antenne (50) assemblée dans le boîtier (30) ;
dans lequel le boîtier (30) est tel que revendiqué dans la revendication 1 ; et l'ensemble de bandes métalliques (330) est positionné en correspondance avec l'antenne (50) de manière à permettre aux signaux de l'antenne (50) de traverser l'ensemble de bandes métalliques (330).

15. Dispositif électronique (100) selon la revendication 14, dans lequel la base (31) comprend un espace de réception (301) et une surface intérieure faisant face à l'espace de réception (301) ; une couche de combinaison étant fixée à la surface interne, la couche de combinaison (37) recouvre les bandes métalliques (33), les couches adhérentes (35), les couches isolantes (36) et recouvre totalement ou partiellement une extrémité de la partie principale (311) reliée aux couches isolantes (36).
